# EUROPÄISCHE PATENTSCHRIFT

(11) **EP 2 686 894 B1**
(45) Veröffentlichungstag und Bekanntmachung des Hinweises auf die Patenterteilung: **06.05.2015**
(21) Anmeldenummer: 12714243.8
(22) Anmeldetag: 15.03.2012
(51) Int. Cl.: H01L 41/12

(54) **AKTUATOR**
ACTUATOR
ACTIONNEUR

(30) Priorität: 16.03.2011 DE 102011014193
(43) Veröffentlichungstag der Anmeldung: 22.01.2014
(73) Patentinhaber: Eto Magnetic GmbH, 78333 Stockach (DE)
(72) Erfinder: SCHIEPP, Thomas, 78606 Seitingen-Oberflacht (DE); LAUFENBERG, Markus, 78333 Stockach (DE)
(74) Vertreter: Behrmann, Niels
(86) Internationale Anmeldenummer: PCT/EP2012/054542
(87) Internationale Veröffentlichungsnummer: WO 2012/123535

(56) Entgegenhaltungen:
- WO-A2-99/45631
- ROLFS K ET AL: "Effect of alloying Ni-Mn-Ga with Cobalt on thermal and structural properties", JOURNAL OF PHYSICS: CONFERENCE SERIES, Bd. 251, 2010, Seiten 012046/1-4, XP55029781, ISSN: 1742-6588, DOI: 10.1088/1742-6596/251/1/012046

## Beschreibung

Die vorliegende Erfindung betrifft einen Aktuator nach dem Oberbegriff des Hauptanspruchs, wie er in der WO 99/45631 offenbart ist.

Elektromagnetische Stellvorrichtungen, bei welchen ein Formgedächtnismaterial (Formgedächtnislegierungsmaterial) als Reaktion auf ein anliegendes Magnetfeld eine Expansion erfährt und daraufhin dann mit einem Stellpartner zum Ausführen einer Stellreaktion zusammenwirken kann, sind aus dem Stand der Technik bekannt. Typischerweise wird dabei dem magnetischen Formgedächtnismaterial (MSM="Magnetic Shape Memory") eine Spulenvorrichtung zugeordnet, welche als Reaktion auf eine Bestromung das zur Expansion des Formgedächtnis-Antriebselements benötigte Magnetfeld erzeugt. Da bei typischen Antriebselement-Konfigurationen, etwa entlang einer vorgesehenen Expansionsachse langgestreckten Körpern, zum Auslösen der Expansionsbewegung ein Magnetfeldeintrag in den Körper orthogonal zur Expansionsrichtung erfolgen muss, ist für eine Realisierung von modulartigen, etwa auch als Ersatz für gängige elektromagnetische Aktuatoren geeignete Anordnungen oder Module, eine kompakte Bauform nur schwierig zu realisieren.

Zwar sieht etwa die unveröffentlichte deutsche Schutzrechtsanmeldung DE 10 2010 010801 der Anmelderin unter Einsatz geeigneter Flussleitelemente für einen Spulen-Magnetfluss eine Möglichkeit vor, wie, analog zu einer herkömmlichen, zylindrischen elektromagnetischen Stellvorrichtung, die Magnetspule koaxial das langgestreckte Antriebselement umschließt, üblicherweise werden jedoch zum Ermöglichen eines magnetischen Flusseintrags in das Antriebselement mindestens zwei Spulenvorrichtungen eingesetzt, welche dann typischerweise beidseits benachbart des MSM-Antriebselementkörpers vorgesehen sind.

Eine derartige, als bekannt vorausgesetzte Konfiguration ermöglicht dann, auch unter Einsatz standardisierter flussleitender Baugruppen zum Realisieren eines magnetischen Flusskreises für das Antriebselement, einfache und reproduzierbare Herstellungseigenschaften, gleichzeitig entstehen jedoch energetische und Volumennachteile:
So wird nämlich, etwa bei Bestromen einer ersten, auf einem zugehörigen Kernabschnitt einer Flussleitstruktur sitzenden Spulenvorrichtung (eines Paares von einander gegenüberliegend bezogen auf ein mittiges Antriebselement vorgesehenen und zueinander sowie zum MSM-Antriebselement magnetisch in Reihe geschalteten Spulenvorrichtungen) ein dadurch erzeugter Magnetfluss in einen gegenüberliegenden Zweig und dort in den Kernbereich der dort vorgesehenen Spulenvorrichtung verdrängt. Entsprechendes gilt für den Fall der Aktivierung dieser gegenüberliegenden Spulenvorrichtung für den Kernbereich der ersten Spulenvorrichtung. Das Ergebnis ist, dass bei zwei aktivierten Spulenvorrichtungen ein jeweiliger wirksamer Querschnitt des Kernbereichs so groß dimensioniert sein muss, dass die einander überlagernden Flüsse beider Spulenvorrichtungen geführt werden können. Nachteilige Folge dieser Einflüsse ist, dass die Baugruppen des magnetischen Kreises (unnötig) groß dimensioniert sein müssen, mit daraus resultierenden Dimensions-, Gewichts- und Kostennachteilen. Dagegen würden bewusst klein dimensionierte Aktuatoren unter diesen Bedingungen Leistungsnachteile mit sich bringen, insbesondere im Hinblick auf eine unerwünschte Erwärmung und/oder verlängerte Bewegungs- und Schaltzeiten.

Zum weiteren Stand der Technik wird verwiesen auf den Artikel Rolfs K et al: "Effect of alloying Ni-Mn-Ga with Cobalt on thermal and structural properties", Journal of physics: conference series, Bd. 251, 2010, Seiten 012046/1-4 (XP55029781).

Aufgabe der vorliegenden Erfindung ist es, einen gattungsgemäßen Aktuator, bei welchen eine Mehrzahl (d.h. mindestens zwei) von Spulenvorrichtungen flusserzeugend auf ein (gemeinsames) Antriebselement aus einem magnetischen Formgedächtnismaterial wirken, so zu verbessern, dass ein wirksamer magnetischer Flusseintrag in das Antriebselement verbessert ist, insbesondere nachteiliger Magnetfluss durch Kernbereiche jeweils anderer Spulenvorrichtungen vermindert oder reduziert ist und, entsprechend die Kompaktheit einer gattungsgemäßen Vorrichtung durch Verringerung von Baugruppendimensionen, insbesondere Querschnittsabmessungen, bei vergleichbaren magnetischen Eigenschaften verbessert werden kann und Bewegungs- und Schaltzeiten bei verringerter Erwärmung erhöht werden können.

Die Aufgabe wird durch den Aktuator mit den Merkmalen des Hauptanspruchs gelöst; vorteilhafte Weiterbildungen der Erfindung sind in den Unteransprüchen beschrieben.

In erfindungsgemäß vorteilhafter Weise ist für jede der (mit dem gemeinsamen Antriebselement zusammenwirkenden) Spulenvorrichtungen ein eigener Flussleitkreis so gebildet, dass in einem Aktivierungs- bzw. Betriebszustand, d.h. bei jeweils bestromten Spulenvorrichtungen, ein Magnetfluss der jeweiligen Spulenvorrichtung im jeweils zugeordneten Flussleitkreis und durch das gemeinsame, aus dem magnetischen Formgedächtnismaterial realisierten Antriebselement geführt wird, gleichzeitig jedoch verhindert wird, dass der Magnetfluss eines ersten Flussleitkreises in den Flussleitkreis einer zweiten Spulenvorrichtung eintritt. Insoweit findet dann in der Art einer magnetischen Parallelschaltung bezogen auf das (gemeinsame) Antriebselement eine wirksame Trennung der jeweiligen Flussleitkreise voneinander statt, mit der vorteilhaften Wirkung, dass die jeweiligen magnetisch flussleitenden Komponenten dieser Flussleitkreise, nämlich die erfindungsgemäßen Kern- und Verbindungsabschnitte, lediglich so ausgelegt und dimensioniert sein müssen, dass diese an den Magnetfluss der jeweils zugehörigen Spulenvorrichtung angepasst sind, jedoch keine zusätzlichen Flusskomponenten jeweils anderer Flussleitkreise (bzw. zugehöriger Spulenvorrichtungen) führen müssen. Magnetisch-konstruktiv wird dies vorteilhaft dadurch erreicht, dass im Betriebszustand die Flussrichtung des Magnetflusses aus den jeweiligen Flussleitkreisen in den (ein- oder mehrstückigen) Flussleitabschnitt für das gemeinsame Antriebselement aufeinander zugerichtet ist und dann im Flussleitabschnitt bzw. durch das Antriebselement in der erfindungsgemäßen Weise gleichgerichtet bzw. gleich ausgerichtet ist; diese Ausgestaltung verhindert damit wirksam, dass entgegen der magnetischen Flussrichtung eines anderen Flussleitkreises ein bestimmter Spulenmagnetfluss einer ersten Spulenvorrichtung durch Verbindungs- und Kernabschnitt in einen anderen Flussleitkreis (außerhalb des parallel geschalteten bzw. gemeinsam/gleich ausgerichtet geführten Flussleitabschnitts) fließen kann.

Vorteilhafte Konsequenz ist, dass die jeweils benötigten Querschnitte der magnetischen Flusskreise, insbesondere im jeweiligen Kernbereich der Spulenvorrichtungen bzw. im Verbindungsabschnitt, signifikant reduziert werden können. Daraus folgt dann einerseits die vorteilhafte Möglichkeit, leichtere und kompaktere Aktuatorvorrichtungen zu realisieren; andererseits ergibt sich eine wesentlich geringere Temperaturentwicklung, welche wiederum die Funktionsfähigkeit des MSM-Formgedächtnismaterials begünstigt (für dessen Funktionsfähigkeit ist typischerweise sicherzustellen, dass Betriebstemperaturen unterhalb der Phasenübergangs- und Curietemperatur für das jeweilige Legierungsmaterial bleiben) und Bewegungs- und Schaltzeiten verkürzt sind.

Dabei ist es im Rahmen bevorzugter Weiterbildungen der Erfindung sinnvoll und bevorzugt, zwei (oder mehr) der Spulenvorrichtungen, durch entsprechende Ausgestaltung der zugehörigen magnetischen Flussleitkreise, so relativ zum Antriebselement vorzusehen, dass die Spulenvorrichtungen beabstandet, insbesondere einander gegenüberliegend, angeordnet sind. Auf diese Weise lässt sich dann eine besonders kompakte Vorrichtung realisieren, welche insbesondere den Eingangs beschriebenen Modulgedanken aufgreift und so die erfindungsgemäße Aktuatorvorrichtung verschiedenen Stelleinsätzen zugänglich macht.

Besonders bevorzugt ist es in diesem Zusammenhang, etwa den Flussabschnitt und einen (typischerweise beidseits einer Spule angreifenden) Verbindungsabschnitt bügelförmig, weiter bevorzugt einstückig auszugestalten, wobei derartige magnetisch flussleitende Körper dann besonders bevorzugt als identisch zu fertigende Baugruppen zu Aktuatoren der vorliegenden Erfindung zusammengesetzt werden können. Bei dieser Realisierungsform würde dann das Antriebselement in einem Übergangsbereich zweier (bevorzugt planar) aufeinanderliegender und weiterbildungsgemäß etwa aus einem magnetisch leitenden Blechmaterial gefertigter Flussleitabschnitte angeordnet sein und so zu einer kompakten Gesamtanordnung beitragen.

Als zusätzliche mögliche Weiterbildung ist jeder der mit dem (gemeinsamen) Antriebselement zusammenwirkenden Spulenvorrichtungen ein eigener Flussleitabschnitt in Form des ersten bzw. weiteren (z.B. zweiten) Flussleitabschnitts zugeordnet, wobei, bei mehr als zwei Spulenvorrichtungen, auch der erste bzw. zweite Flussleitabschnitt von mehr als einer Spulenvorrichtung mit Magnetfluss beaufschlagt werden kann. Hierdurch wird vorteilhaft die Voraussetzung dafür geschaffen, dass zwar der erste bzw. der zweite Flussleitabschnitt jeweils dem Magnetfluss der zugeordneten Spulenvorrichtung in das (gemeinsam) zugeordnete Antriebselement einleitet, die jeweiligen magnetischen Flusskreise jedoch voneinander getrennt bzw. geeignet voneinander entkoppelt werden können.

Konstruktiv ist es im Rahmen bevorzugter Ausführungsformen der Erfindung günstig, einen einstückigen, von der Mehrzahl der Flussleitkreise gemeinsam genutzten Flussleitabschnitt, alternativ einen ersten sowie einen weiteren Flussleitabschnitt als zweite getrennte und/oder entkoppelte flussleitende Abschnitte jeweiliger Flussleitkreise, etwa verlaufend entlang einer Erstreckungsrichtung der Spulenvorrichtungen, langgestreckt auszubilden und so parallel zueinander zu führen, dass in oben beschriebener Weise eine kompakte, modulare Bauform im Zusammenwirken entsteht, gleichzeitig ist, durch etwa die ansonsten bekannte Blechtechnologie, eine hinreichende magnetflussmäßige Trennung bzw. Entkopplung zwischen den jeweiligen Kreisen gewährleistet. Die alternative Realisierungsform eines einstückigen und/oder gemeinsamen Flussleitabschnitts für das Antriebselement lässt sich gleichermaßen mechanischkonstruktiv und modular mittels geeigneter Blechelemente o.dgl. Baugruppen realisieren. Im Rahmen dieser bevorzugten Ausführungsformen, jedoch auch unabhängig von diesen ist es weiterbildungsgemäß bevorzugt, das Antriebselement aus dem magnetischen Formgedächtnismaterial querschnittlich rechteck- und/oder vieleckförmig auszugestalten, also nicht-zylindrisch und mit bevorzugt planen Außenflächen dergestalt, dass im Zusammenwirken mit dem Verbindungsabschnitt (welcher wiederum bevorzugt entsprechend plane Eingriffsflächen aufweist) ein möglichst guter magnetischer Flusseintrag in das Antriebselement erfolgen kann. Wiederum weiterbildungsgemäß und/oder unabhängig von diesem Ansatz ist es dabei bevorzugt, das Antriebselement so auszugestalten, dass der eingetragene magnetische Fluss nicht entlang der längsten Achse oder Erstreckungsdimension des Antriebselements erfolgt, vielmehr bevorzugt entlang bzw. in einer kurzen, weiterbildungsgemäß etwa der kürzesten, Achse.

Besonders bevorzugt und weiterbildungsgemäß ist es vorgesehen, den erfindungsgemäßen Aktuator um Permanentmagnetmittel zu ergänzen. Diese gestatten eine Optimierung der Vorrichtung in mehrfacher Hinsicht; so ist es einerseits möglich, durch entsprechende Integration eines Permanentmagnetkörpers (bzw. Abschnitts aus einem Permanentmagnetmaterial) in mindestens einen der magnetischen Flusskreise für eine (permanent-) magnetische Vorspannung des MSM-Antriebelements zu sorgen, so dass dann etwa ein geringerer (überlagerter) Spulenmagnetfluss erforderlich ist, um die gewünschte Expansionsreaktion auszulösen. Auch lässt sich mit Hilfe eines Permanent-Magnetelements, etwa im zusätzlichen Zusammenwirken mit einer entgegenwirkenden Druckfeder, ein bistabiles Schaltverhalten des Antriebselements realisieren.

Ergänzend oder alternativ ist es im Rahmen bevorzugter Weiterbildungen der Erfindung vorgesehen, die Permanentmagnetmittel so anzuordnen und mit dem magnetischen Flussleitkreis zusammenwirken zu lassen, dass der permanentmagnetische Fluss gezielt vom Bestromungszustand einer zugehörigen Spulenvorrichtung beeinflusst bzw. geschaltet wird: so ist es beispielsweise vorgesehen und günstig, die Permanentmagnetmittel so in den magnetischen Flussleitkreis einzuschleifen, dass als Reaktion auf das elektrische Ansteuern der Spulenvorrichtung der Permanentmagnetfluss (von einem Fließen durch den Kernbereich der Spulenvorrichtung in unbestromten Zustand) in das Antriebselement verdrängt wird. Insoweit ermöglicht die Erfindung in besonders einfacher und eleganter Weise eine gezielte Beeinflussung des magnetischen Flussverhaltens im Aktuator, wiederum mit positiven Auswirkungen auf Baugröße, Erwärmung und Schaltverhalten.

Dieser Erfindungsaspekt bekommt eine besondere Bedeutung dann, wenn gezielt und durch Verwendung derartiger, magnetisch parallel zu mindestens einer der Spulenvorrichtungen geschalteter Permanentmagnetmittel (Parallel-Permanentmagnetmittel) eine gezielte Magnetflusserhöhung im Antriebselement durchgeführt wird, nämlich dadurch, dass als Reaktion auf eine Aktivierung (Bestromung) einer Spulenvorrichtung das Permanentmagnetfeld in das Antriebselement verdrängt wird, gleichzeitig, in der Art eines an- bzw. ausgelagerten parallelen Permanentmagnetzweigs, solche Parallel-Permanentmagnetmittel konstruktiv vorteilhaft und einfach an ein geeignetes flussführendes Gehäuse des Aktuators an- bzw. eingebracht werden können.

Mechanisch und mit dem Zweck, den erfindungsgemäßen Aktuator als Modulbaugruppe auszubilden, ist es besonders bevorzugt, diesen in einem Gehäuse oder einer vergleichbaren Kapselstruktur vorzusehen, dabei ist es sowohl möglich und weiterbildungsgemäß von der Erfindung umfasst, in ansonsten bekannter Weise der erfindungsgemäßen Anordnung eine Schale zuzuordnen, wobei dann entweder diese Schale, im oben beschriebenen Sinne, vollständig oder teilweise magnetisch flussleitend ausgebildet sein kann und so Teil etwa eines Kurzschlusszweiges für die weiterbildungsgemäß vorgesehenen (Parallel-)Permanentmagnetmittel sein kann, zusätzlich vorteilhaft streuflussmindernd wirkt, wie auch (ergänzend oder alternativ) die Baugruppen mit einem magnetisch nicht leitenden Material, bevorzugt einem Kunststoff, zu umspritzen, so dass lediglich ein Zugriff auf das bewegbare Antriebselement verbleibt.

Im Ergebnis gestattet es die vorliegende Erfindung in einfacher und eleganter Weise, die Magnetfeld-Vorteile einer Mehrzahl von Spulenvorrichtungen (etwa gegenüber einer einzelnen Spule) im Hinblick auf das MSM-Antriebselement zu kombinieren mit optimiertem, Ohmsche Verluste sowie Wärmeentwicklung reduzierendem Flussleitaufbau, welcher, neben konstruktiver Einfachheit, kurze Schalt- und Bewegungszeiten ermöglicht.

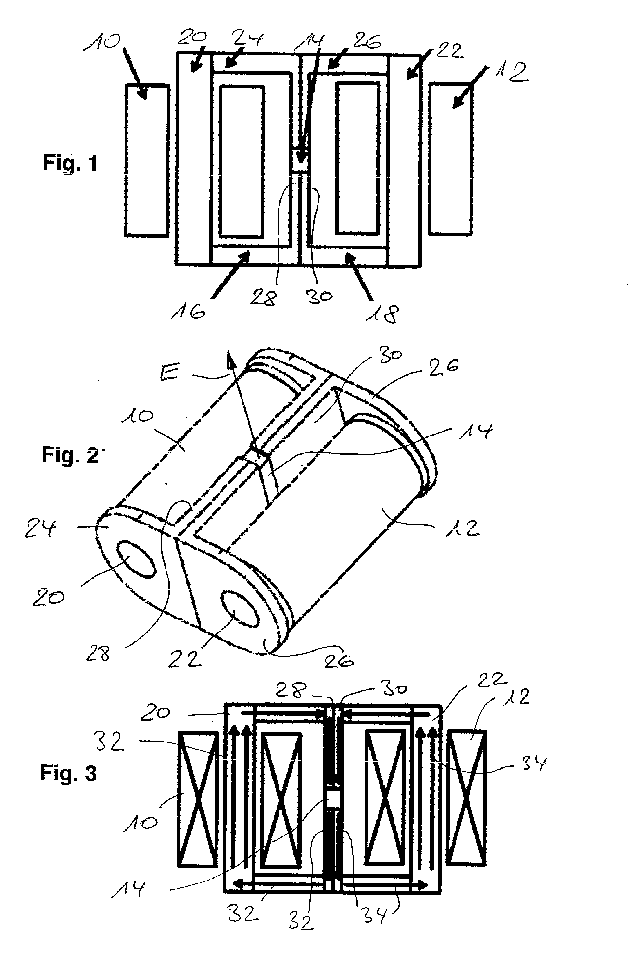

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in
- Fig. 1: eine schematische Schnittansicht einer ersten Ausführungsform des erfindungsgemäßen Aktuators als Anordnung mit zwei Spulenvorrichtungen;
- Fig. 2: eine Perspektivansicht einer praktischen Realisierung des aus in Fig. 1 gezeigten konzeptuellen Ausführungsbeispiels;
- Fig. 3: eine Ansicht analog Fig. 1 mit schematisch dargestelltem magnetischem Flussverlauf in den jeweiligen (getrennten) Flussleitkreisen;
- Fig. 4 bis 6: verschiedene Varianten zum Einbringen von (in Flussverlaufsrichtung magnetisierten) Permanentmagnetkörpern bzw. - abschnitten in die Flussleitkreise der Fig. 3, Fig. 1;
- Fig. 7 bis 9: eine weitere Ausführungsform der Erfindung mit zusätzlich vorgesehenen Permanentmagnetmitteln zur Weiterbildung des Realisierungsprinzips der Fig. 2, wobei die Fig. 8 den bestromten Zustand der Spulenvorrichtungen und die Fig. 9 deren unbestromten Zustand zeigt,
- Fig. 10: ein weiteres Ausführungsbeispiel des Aktuators, wobei sowohl der erste Flussleitabschnitt, als auch der zweite Flussleitabschnitt jeweils eine Mehrzahl von Spulenvorrichtungen zugeordnet aufweist;
- Fig. 11, 12:: Varianten des Ausführungsbeispiels der Fig. 2 mit nahezu vollständig (Fig. 11) bzw. teilflächig (Fig. 12) geschlossenem Gehäusemantel zur magnetischen Streufeldminderung;
- Fig. 13, 13:: Varianten der Ausführungsbeispiele der Fig. 11, 12 für eine Anordnung aus jeweils vier Spulen;
- Fig. 15, 16:: eine schematische Darstellung analog Fig. 1, jedoch zum Verdeutlichen seitlich ausgelagerter und zum gesteuerten Überlagern bzw. Verdrängen eines Permanentmagnetflusses ansitzender (Parallel-) Permanentmagnete.
Eine erste Ausführungsform der Erfindung, dargestellt in den Fig. 1 bis 3, weist einen Aktuator mit zwei Spulenvorrichtungen 10, 12 auf, welche, einander bezogen auf ein langgestrecktes MSM-Antriebselement 14 (Expansionsrichtung aus der Bildebene der Fig. 1 senkrecht heraus) gegenüber stehen. Den Spulenvorrichtungen 10 bzw. 12 sind jeweilige magnetische Flussleitkreise 16 bzw. 18 zugeordnet, bestehend aus von den Spulen 10, 12 umschlossenen Kernbereichen 20 bzw. 22, daran anschließenden Verbindungsabschnitten 24 bzw. 26 und jeweils einen Magnetfluss der bestromten Spulen 10, 12 in das Antriebselement 14 eintragenden Flussleitabschnitten 28 bzw. 30.

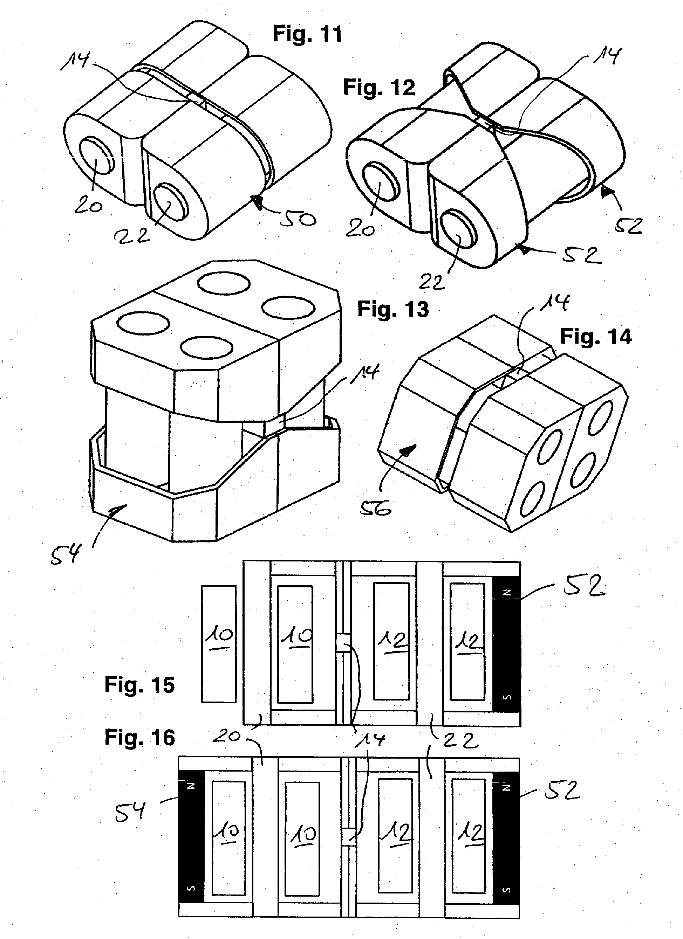

In der praktischen Realisierung, vergleiche die Perspektivansicht eines möglichen Aufbaus der Fig. 2, sind die Flussleitabschnitte 28 bzw. 30 ausgebildet als flache Mittenabschnitte eines beidends eine jeweilige Spule 10 bzw. 12 (genauer: den jeweiligen mittigen Kernabschnitt derselben) umgreifenden Bügelanordnung, bevorzugt gefertigt aus einem (Transformatoren-) Blechmaterial oder dergleichen magnetisch leitendem Flachmaterial, und in der in Fig. 2 gezeigten Weise im mittleren Bereich jeweils unterbrochen zum Aufnehmen des Antriebselements 14. Dessen Expansionsrichtung ist durch den Pfeil E in Fig. 2 verdeutlicht. Weiterbildungen dieser Variante zeigen zunächst die Fig. 11, 12 mit Gehäuseflächen 50, 52 aus magnetisch leitendem Material, welche sich lateral und zum Ausbilden einer Streufeldabschirmung erstrecken. Wiederum variiert wird diese Ausführungsform durch eine Anordnung aus vier Spuleneinheiten, welche mit entsprechend teilflächig bzw. vollständig ausgebildeten Gehäusemantelabschnitten 54, 56 ausgebildet sind.

Die Fig. 3 zeigt, wie bei Bestromung der Spulen 10, 12 des Ausführungsbeispiels ein sich addierender magnetischer Flussverlauf aus Einzelflüssen 32 bzw. 34 der jeweiligen magnetischen Flussleitkreise durch das gemeinsam mit dem Fluss beaufschlagte Antriebselement geführt wird; gleichzeitig verdeutlicht der Pfeilverlauf, dass (idealisiert dargestellt) keine magnetische Kopplung zwischen den jeweiligen Einzelkreisen stattfindet, vielmehr ein Verlauf etwa von Flusskomponenten des Flusses 32 im Bereich des Kerns 22 ebenso verhindert wird, wie umgekehrt keine Komponente des Flusses 34 den Kernbereich 20 erreicht. Damit verdeutlicht diese Darstellung, wie, gemäß der vorliegenden Erfindung, die Flusskomponenten 32 bzw. 34 zueinander gleich ausgerichtet (gleichgerichtet) durch die Flussabschnitte 28 bzw. 30 verlaufen (wobei diese alternativ auch als einstückiger/oder gemeinsamer Flussabschnitt ausgestaltet sein können), so dass in der Darstellung der Fig. 3 die jeweiligen Flussleitkreise, bezogen auf das Antriebselement 14, eine Parallelschaltung der jeweiligen magnetischen Flüsse der Einzelkreise (der Spulenvorrichtungen 10 bzw. 12) erfahren. Wie zudem die zwei Verläufe der jeweiligen Flussleitkreise der Fig. 3 verdeutlichen, wird durch diese erfindungsgemäße Vorgehensweise sinnvoll verhindert, dass ein Magnetfluss aus einem ersten Kernbereich (z.B. 20 über dem zugehörigen Verbindungsabschnitt 24) in einen Verbindungsabschnitt 26 des zweiten Kernbereichs 22 eintritt; vielmehr findet durch die gegeneinander gerichtete Flussrichtung in den einander benachbarten Verbindungsabschnitten 24 und 26 ein jeweiliges Ablenken der Flusskomponenten (32, 34) in die Flussleitabschnitte 28, 30 statt, zum Bewirken der erfindungsgemäßen Parallelschaltung bzw. gleichgerichteten Magnetflussführung.

Damit können die Kerne vorteilhaft ohne die Gefahr magnetischer Sättigung klein dimensioniert werden, mit den Vorteilen entsprechend klein dimensionierter Spulen sowie einer kompakten Gesamtanordnung. Bedarfsweise und in ansonsten bekannter Weise kann dem Antriebselement eine Rückstellvorrichtung zugeordnet sein (da üblicherweise, bei sich im gezeigten Ausführungsbeispiel frei expandierbarem MSM-Formgedächtniskörper, dieser nach dem Beenden einer Magnetfeldbeaufschlagung in seiner expandierten Position verbleibt und, etwa durch mechanischen Angriff, zurückgestellt werden muss). Hier bieten sich zahlreiche, ansonsten aus dem Stand der Technik bekannte Vorgehensweisen an, etwa das Vorsehen einer (Druck-) Federeinheit oder dergleichen Kraftspeicher, das Vorsehen eines anderen Aktuators (möglicherweise auch wiederum als MSM-Aktuator konfiguriert), oder dergleichen Mittel.

Die in Fig. 1 gezeigte Vorrichtung, wie auch die nachfolgend zu beschreibenden Ausführungsbeispiele, realisieren in vorteilhafter Weise die Vorteile mehrerer parallel bzw. überlagert zu betreibender Spulen zur Flusserzeugung, ohne dass etwa wie im Stand der Technik zu erkennen, eine zu große Erwärmung die Betriebseigenschaften und die Effizienz der Vorrichtung nachteilig beeinflusst. Auch gestattet die vorliegende Erfindung in vorteilhafter Weise das Realisieren sehr kurzer Schaltzeiten (und damit verbunden hoher Betriebsfrequenzen für eine Bewegung des Antriebselements), insbesondere relativ zu bekannten elektromagnetischen Aktuatoren, da der eigentliche Expansions-Schaltvorgang im MSM-Material sehr schnell erfolgt. Zeitkritisch für das Zeitverhalten ist daher lediglich die Realisierung des magnetischen Kreises bzw. die Geschwindigkeit, mit welcher das Spulmagnetfeld auf- und abgebaut werden kann (wobei dessen Zeitkonstante wiederum vom Ohmschen Spulenwiderstand sowie der Spuleninduktivität beeinflusst wird). Wird dann, wie weiterbildungsgemäß vorgesehen, etwa eine elektrische Reihenschaltung entsprechend optimierter Spulenanordnungen vorgesehen, ohne dass, wie erfindungsgemäß vorteilhaft erreicht, eine gegenseitige Flussbeeinflussung erfolgt (so dass, bezogen auf den Magnetkreis und das MSM-Element, die Spulen-Magnetflüsse parallel eingetragen werden), ist eine leistungsfähige Optimierung des Zusammenwirkens eines Antriebselements mit mehreren Spulenvorrichtungen zum Erzeugen des Bewegungs-Magnetfeldes erreicht.

Eine alternative Realisierungsform als Ausführungsform der Erfindung, in den Figuren nicht gezeigt, sieht vor, dass anstelle von zwei separat ausgeführten und zueinander parallel ausgerichteten Flussleitabschnitten (28 bzw. 30 in Fig. 1 bzw. Fig. 3) ein gemeinsamer Flussleitabschnitt vorgesehen ist. Auch hier tritt die vorteilhafte Flussführung der Fig. 3 (entsprechend dem Pfeilverlauf 32, 34) auf, so dass der erfindungsgemäße Vorteil der magnetischen Parallelschaltung bzw. einer jeweiligen Verdrängung von magnetischen Flusskomponenten aus einem jeweils gegenüberliegenden Flussleitkreis erreicht werden kann.

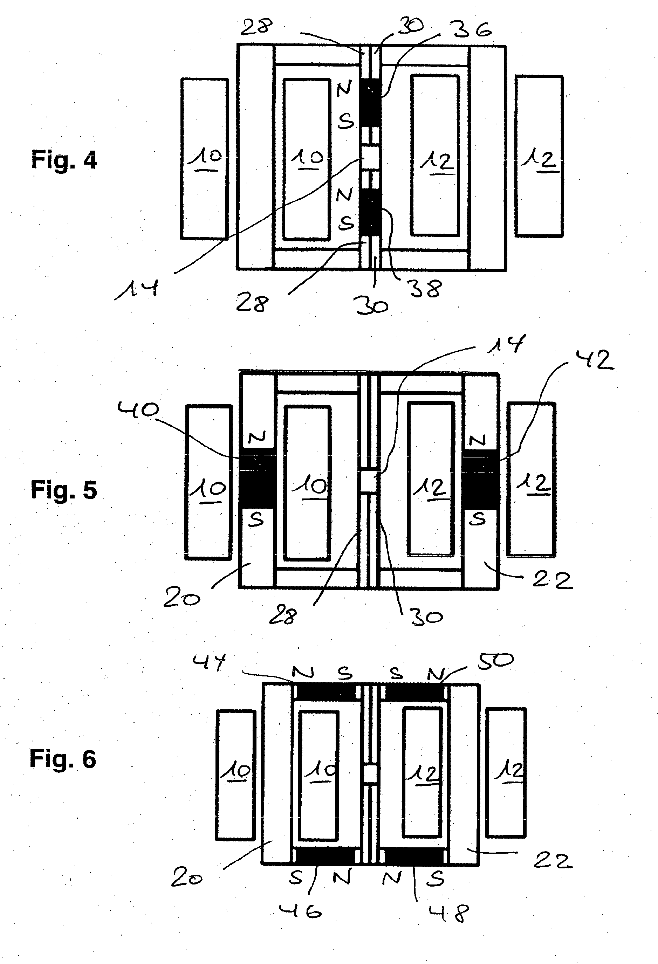

Die Figuren 4 bis 6 zeigen eine bevorzugte Weiterbildung der Erfindung, bei welcher Permanentmagnetmittel, typischerweise in Form von Abschnitten der magnetischen Flusskreise aus permanentmagnetischem Material mit einer Permanentmagnetisierung entlang der Flussrichtung, in verschiedene Abschnitte des magnetischen Flussleitkreises eingeschleift sind und so etwa eine magnetische Vorspannung (durch Überlagerung des Permanentmagnetfeldes mit einem jeweiligen Spulenmagnetfeld) bewirken. Das Ergebnis ist eine weitere Verkürzung der Schalt- bzw. Expansionszeit, ein geringeres notwendiges Spulenmagnetfeld oder dergleichen: so zeigt das Ausführungsbeispiel der Figur 4, wie Permanentmagnete 36, 38 im Bereich beider Flussleitabschnitte 28, 30 vorgesehen sind, vorteilhaft sogar gemeinsam von den jeweiligen magnetischen Flussleitkreisen genutzt werden. Die Variante der Figur 5 ordnet jeweilige Permanentmagnetabschnitte 40, 42 den Kernabschnitten 20 bzw. 22 (unterhalb jeweiliger Spulenwicklungen 10, 12) zu, und die weitere Variante der Figur 6 bildet die Verbindungsabschnitte 24 bzw. 26 in den jeweiligen magnetischen Flusskreisen 16 bzw. 18 mit in den jeweiligen Flussrichtungen gepolten Permanentmagnetelementen 44, 46, 48, 50 aus.

Permanentmagnete, etwa entsprechend der Figuren 4 bis 6, ermöglichen zusätzlich vorteilhaft und durch Ausnutzung der Hysterese des MSM-Formgedächtnismaterials ein stromlos bistabiles Schaltverhalten: indem nämlich (in den Figuren nicht gezeigt) das Antriebselement 14 gegen eine Druckfeder oder dergleichen Kraftspeicher mechanisch vorgespannt wird, kann durch (impulsförmiges) Bestromen der Spulenanordnung 10, 12 und bei geeigneter Dimensionierung der Feder-Gegenkraft das Antriebselement zwischen einer expandierten und einer zurückgezogenen Position umgeschaltet werden und dauerhaft stromlos dort verbleiben.

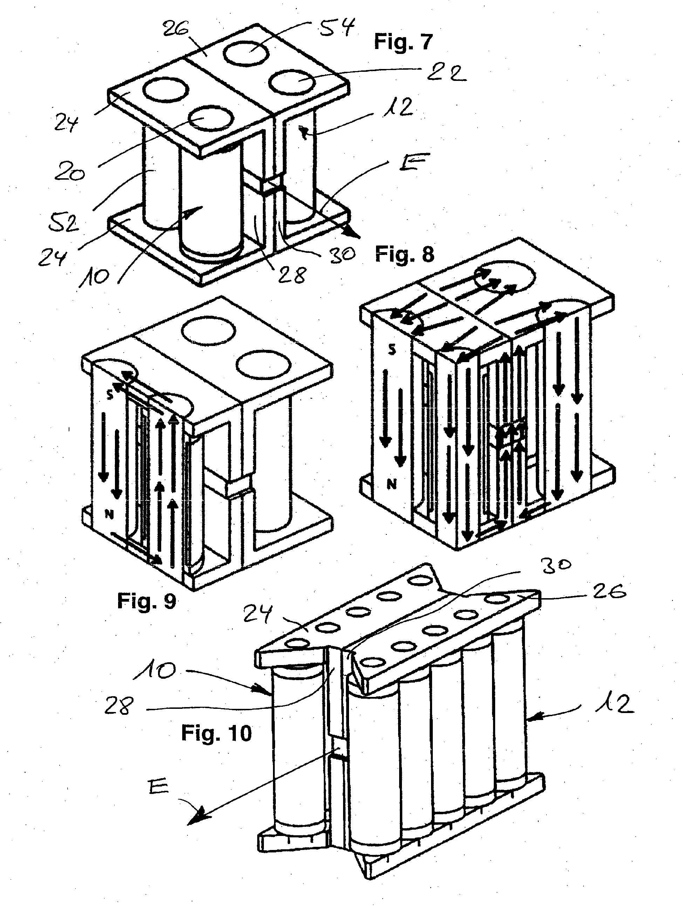

Das Ausführungsbeispiel der Fig. 7 bis 9 zeigt eine weitere Möglichkeit, Permanentmagnetmittel in den magnetischen Flussleitkreis zu integrieren und den Flussverlauf durch das Antriebselement 14 schalt- bzw. steuerbar zu optimieren.

Analog zu Realisierungsform der Fig. 2 ist wiederum eine jeweilige Spulenvorrichtung 10 bzw. 12 für einen jeweiligen magnetischen Flussleitkreis 16 bzw. 18 verbunden mit einer bügelartigen Anordnung aus erstem (28) bzw. zweitem (30) Flussleitabschnitt sowie zugehörigen Verbindungsabschnitten als Schenkel der jeweiligen U-profilförmigen Blechanordnungen. Das Antriebselement ist orthogonal zu den Spulenachsen zwischen hälftig aufgetrennten Flussleitabschnitten gehalten und weist eine Expansionsrichtung entlang Pfeil E auf.

Benachbart zu den Spuleneinheiten 10, 12 ist jeweils ein Permanentmagnet 52 bzw. 54 vorgesehen, welcher, vgl. die Schnittansicht der Fig. 9, entsprechend der Spulen-Erstreckungsrichtung und orthogonal Pfeilrichtung E axial magnetisiert ist. Durch die flussleitenden Schenkelabschnitte 24 bzw. 26 (Verbindungsabschnitt) erfolgt im unbestromten Zustand (Fig. 9) ein Permanentmagnetfluss durch einen jeweiligen Kern 20 bzw. 22 der magnetischen Flussleitkreise, wie der Pfeilverlauf der Fig. 9 verdeutlicht.

Sobald jedoch, wie in Fig. 8 gezeigt, durch Bestromung der Spulen 10 und 12 ein Spulenmagnetfeld zusätzlichen magnetischen Fluss erzeugt, verdrängt dieser den Flussverlauf eines jeweiligen zugeordneten Permanentmagneten 52 bzw. 54 aus den Kernbereichen in die Flussleitabschnitte 28 bzw. 30, mithin bewegungswirksam in das Antriebselement (da das MSM-Material selbst einen relativ hohen magnetischen Widerstand aufweist, ist es im unbestromten Zustand der Fig. 9 vom Permanentmagnetfluss praktisch unbeeinflusst geblieben).

Damit lässt sich in weiterbildungsgemäß vorteilhafter Weise erreichen, dass ein zusätzlich vorspannendes bzw. unterstützendes Permanentmagnetfeld in einem unbestromten Zustand der Spulenvorrichtungen (und im Gegensatz zu den Ausführungsbeispielen der Fig. 4 bis 6) das MSM-Material nicht erreicht, während das Aktivieren der Bestromung dazu führt, dass, in der Art einer Umleitung, nicht nur der Spulenmagnetfluss expansionswirksam durch das Antriebselement geführt wird, sondern ergänzend und verstärkend auch das Permanentmagnetfeld. Auch hierdurch lassen sich Geschwindigkeitsvorteile erreichen, insbesondere durch ein für einen Bewegungs- bzw. Schaltvorgang geringeres benötigtes Spulenfeld ferner Größenvorteile durch eine kleinere benötigte Spulenbauform.

Die schematischen Schnittdarstellungen der Fig. 15, 16 verdeutlichen, unter Bezug und in konstruktiver Weiterentwicklung der Schemadarstellung der Fig. 1, dieses Funktionsprinzip: Ein ausgelagerter Permanentmagnet 52 (Fig. 7) in Fig. 15 bzw. zwei jeweils außen und seitlich ausgelagerte Permanentmagnete 52, 54 werden durch den bzw. die Kernbereich/en 20, 22 magnetisch kurzgeschlossen. Eine Bestromung der Spulen 10 und 12 bewirkt dann eine Verlagerung und mithin Addierung des Permanentmagnetfelds im Hinblick auf das Antriebselement 14. Dabei ist die konstruktive Realisierung nicht auf die schematische Darstellung etwa der Fig. 7 bis 9 beschränkt, so kann die mindestens eine Permanentmagneteinheit auch geeignet außen auf einem magnetisch leitenden und insoweit als Teil des magnetischen Kreises wirkenden Gehäuse des Aktuators vorgesehen sein, wobei dann etwa dieser Gehäuseabschnitt den bzw. die Permanentmagneteinheit/en magnetisch kurzschließt und als Reaktion auf die Spulenbestromung dann die Verdrängung und Verlagerung des Permanentmagnetflusses eintritt. Wiederum alternativ (und in den Figuren nicht dargestellt) ist die Möglichkeit, die mindestens eine Permanentmagneteinheit geeignet in einem Ausschnitt bzw. einem Durchbruch eines flussleitende Gehäuses des Aktors vorzusehen, wiederum mit denselben flussleitenden bzw. ausgelagerten Magnetflusseigenschaften.

Über das in den Fig. 7 bis 9 gezeigte Prinzip hinaus, bietet es sich zudem weiterbildungsgemäß und vorteilhaft im Rahmen der Erfindung an, einen Permanentmagneten beispielsweise ringförmig und mit axialer Magnetisierung auszugestalten und um eine Spule einer Spulenvorrichtung herum vorzusehen, so dass, zur Realisierung dieser vorteilhaften Wirkungen, eine magnetische Parallelschaltung der Flusswirkung erfolgt.

Die Fig. 10 zeigt eine weitere mögliche Variante im Rahmen bevorzugter Ausführungsbeispiele, wobei hier - exemplarisch für zahlreiche andere Varianten - eine Weiterbildung der Bauform der Fig. 2 dahingehend gezeigt ist, dass für jeden der zwei Flussleitabschnitte (bzw. zugehöriger weiterer Komponenten des magnetischen Flussleitkreises) eine Mehrzahl von fünf Spulen (mit jeweils mittig vorgesehenem Kernelement) vorgesehen ist, mit dem Ergebnis, dass in vorbeschriebener vorteilhafter Weise Vorteile im Hinblick auf Schaltgeschwindigkeit, Erwärmungsverhalten oder dergleichen realisiert werden können.

Die vorliegende Erfindung ist nicht auf die vorbeschriebenen Ausführungsbeispiele beschränkt. So bietet es sich beispielsweise an, durch Einsatz geeigneter flussleitender Materialien (wie geblechten Flussleitteilen, dem Einsatz von Spezialwerkstoffen, etwa Siliziumstählen mit reduzierter elektrischer Leitfähigkeit und gleichzeitig guten magnetischen Eigenschaften) die Schaltgeschwindigkeit zusätzlich zu erhöhen.

Während die Flussleitkreise in den gezeigten Ausführungsbeispielen bügelförmig dargestellt wurden, ist es im Rahmen bevorzugter Weiterbildungen der Erfindung möglich, diese anders, auch aus einer Mehrzahl von Einzelkomponenten zusammenzufügen, wobei es sich hier insbesondere anbietet, Gleichteile zu verwenden, um insoweit in der Art eines Baukastenprinzips Systeme für verschiedene Anwendungen (etwa mit einer zu variierenden Anzahl von Spuleneinheiten) zu erstellen.

Auch können, in Weiterentwicklung des Gedankens der Fig. 10, die Spulen über- oder nebeneinander oder in sonstiger Kombination angeordnet werden, je nach Bauraumanforderungen. Auch können die Spulen im Hinblick auf die Ausgestaltung von Wicklungen, Windungszahlen oder dergleichen jeweiligen Anforderungen geeignet angepasst werden.

In den Figuren sind weder Gehäuse- noch Spulenträgerstrukturen gezeigt. Diese können gleichwohl, je nach Erfordernis vorgesehen sein, wobei alternativ auch der Spulendraht einer Spulenvorrichtung direkt auf den (ggf. vorher für eine höhere Durchschlagfestigkeit beschichteten) Kernabschnitt gewickelt sein kann, wiederum mit Vorteilen für Kosten und Bauraum.

Im Hinblick auf Gehäusestrukturen ist es denkbar, die gezeigten Anordnungen oder Varianten davon in geeignete Gehäuseschalen einzusetzen, ergänzend oder alternativ ein Umspritzen mit ansonsten bekannten Kunststoffmaterialen aus Schutz- und/oder Stabilitätszwecken vorzunehmen.

## Patentansprüche

1. Aktuator mit
einem als Reaktion auf eine elektrische Ansteuerung einer Mehrzahl von Spulenvorrichtungen (10, 12) antreibbaren und zum Durchführen einer Expansionsbewegung als Reaktion auf die Ansteuerung ausgebildeten Antriebselement aus einem magnetischen Formgedächtnismaterial, wobei die Spulenvorrichtungen über Flussleitmittel (20, 22, 24, 26, 28, 30) mit dem Antriebselement (14) magnetisch verbunden sind und den Spulenvorrichtungen ein Flussleitabschnitt der Flussleitmittel zum Zusammenwirken mit dem Antriebselement zugeordnet ist,
die Flussteitmittel für jede der Mehrzahl der Spulenvorrichtungen einen Kernabschnitt (20, 22, 30) sowie einen einen Magnetfluss zum Antriebselement leitenden Verbindungsabschnitt (24, 26) so aufweisen, dass für die Spulenvorrichturtgen jeweils ein magnetischer Flussleitkreis durch das gemeinsame Antriebselement gebildet ist, und
die Flussleitkreise, bezogen auf das gemeinsame Antriebselement, zueinander magnetisch parallel geschaltet sind und/oder eine magnetische Flussrichtung eines Magnetflusses im jeweiligen Flussleitkreis im Antriebselement gleich ausgerichtet ist,
**dadurch gekennzeichnet,**
**dass** das Antriebselement querschnittlich rechteck- und/oder vieleckförmig und mit planen Außenflächen ausgestaltet ist und ein magnetischer Flusseintrag in das Antriebselement nicht entlang einer längsten Achse oder Erstreckungsdimension des Antriebselements erfolgt.

2. Aktuator nach Anspruch 1, **dadurch gekennzeichnet, dass** zwei der Mehrzahl der Spulenvorrichtungen voneinander beabstandet und bevorzugt, bezogen auf das Antriebselement, einander gegenüberliegend angeordnet sind.

3. Aktuator nach Anspruch 1 oder 2, **dadurch gekennzeichnet, dass** in die Flussleitkreise ein gemeinsamer Flussleitabschnitt zum Zusammenwirken mit dem Antriebselement eingeschleift ist.

4. Aktuator nach Anspruch 1 oder 2, **dadurch gekennzeichnet, dass** einer ersten der Mehrzahl der Spulenvorrichtungen ein erster Flussleitabschnitt (28) der Flussleitmittel zum Zusammenwirken mit dem Antriebselement zugeordnet ist,
mindestens einer weiteren (12) der Mehrzahl der Spulenvorrichtungen ein zweiter Flussleitabschnitt (30) der Flussleitmittel zum Zusammenwirken mit dem Antriebselement zugeordnet ist
und der erste (28) und der zweite (30) Flussleitabschnitt einander benachbart vorgesehen und so magnetisch voneinander getrennt und/oder entkoppelt ausgebildet sind, dass eine wechselseitige Magnetflussübertragung und/oder Magnetflusskopplung zwischen dem ersten und dem zweiten Flussleitabschnitt verhindert oder reduziert ist, insbesondere im Vergleich zu einem anstelle des ersten und des zweiten Flussleitabschnittes vorzusehenden gemeinsamen und/oder einstückigen flussleitenden Körper.

5. Aktuator nach Anspruch 4, **dadurch gekennzeichnet, dass** der erste und der zweite Flussleitabschnitt zumindest abschnittsweise langgestreckt und zueinander parallel verlaufend ausgebildet sowie zum Eintragen eines Magnetflusses das Antriebselement gemeinsam kontaktierend ausgebildet sind.

6. Aktuator nach einem der Ansprüche 1 bis 5, **dadurch gekennzeichnet, dass** der Flussleitabschnitt und der Verbindungsabschnitt bügelförmig, bevorzugt einstückig und/oder aus einem ein- oder mehrstückigen magnetisch leitendem Blechmaterial ausgebildet sind.

7. Aktuator nach einem der Ansprüche 1 bis 6, **dadurch gekennzeichnet, dass** jeder der Mehrzahl der Spulenvorrichtungen ein geschlossener magnetischer Flussleitkreis so zugeordnet ist, dass um einen jeweiligen Kernabschnitt des Flussleitkreises die Spulenvorrichtung herum vorgesehen, der Flussleitabschnitt dem Kernabschnitt gegenüberliegend im Flussleitkreis ausgebildet ist und die Mehrzahl der den Spulenvorrichtungen zugeordneten Kernabschnitte (20, 22), bezogen auf das Antriebselement, radial auswärts und/oder sich zueinander achsparallel erstreckend vorgesehen ist.

8. Aktuator nach einem der Ansprüche 1 bis 7, **gekennzeichnet durch** Permanentmagnetmittel (36-54), die als Abschnitt aus einem Permanentmagnetmaterial mit den Flussleitmitteln magnetisch flussleitend verbunden und/oder in einen magnetischen Flussleitkreis für mindestens einen der Flussleitabschnitte eingeschleift sind.

9. Aktuator nach Anspruch 8, **dadurch gekennzeichnet, dass** die Permanentmagnetmittel (36-50) so in den magnetischen Flussleitkreis eingeschleift sind, dass in einem unbestromten Ansteuerzustand einer zugehörigen Spulenvorrichtung ein Permanentmagnetfluss durch einen Kernabschnitt des magnetischen Flussleitkreises fließt und der Permanentmagnetfluss als Reaktion auf die elektrische Ansteuerung der Spulenvorrichtung und eine dadurch bewirkte Flusskomponente in den zugehörigen Flussleitabschnitt und das Antriebselement verdrängt wird.

10. Aktuator nach Anspruch 8 oder 9, **dadurch gekennzeichnet, dass** die Permanentmagnetmittel (36-50) als in einer magnetischen Flussrichtung magnetisierter Körper Teil des Flussleitabschnittes oder eines der Flussleitabschnitte, eines einer der Spulenvorrichtungen zugeordneten Kernabschnitts und/oder eines den Kernabschnitt mit dem Antriebselement verbindenden Verbindungsabschnitts eines betreffenden magnetischen Flussleitkreises ist.

11. Aktuator nach einem der Ansprüche 8 bis 10, **dadurch gekennzeichnet, dass** die Permanentmagnetmittel (36, 38) als einem oder einer Mehrzahl der Flussleitabschnitt/e bevorzugt gemeinsam zugeordneter Körper aus dem Permanentmagnetmaterial ausgebildet sind.

12. Aktuator nach einem der Ansprüche 1 bis 11, **dadurch gekennzeichnet, dass** mindestens eine der Spulenvorrichtungen als Drahtwicklung ohne zwischenliegenden Spulenkörper unmittelbar auf einem Kernabschnitt der Flussleitmittel vorgesehen ist.

13. Aktuator nach einem der Ansprüche 1 bis 12, **gekennzeichnet durch** dem Antriebselement zugeordnete Rückstellmittel, die mechanisch mit dem Antriebselement gekoppelt und bevorzugt als zusätzlicher gegenwirkender, ein Formgedächtnismaterial aufweisender Aktuator oder mittels eines Permanentmagneten und/oder als Kraftspeicher realisiert sind.

14. Aktuator nach einem der Ansprüche 1 bis 13, **gekennzeichnet durch** Gehäusemittel, die als den Aktuator und/oder die Spulenmittel zumindest teilweise umschließende Schale aus magnetisch leitendem Werkstoff und/oder Umspritzung, insbesondere mittels eines Kunststoffmaterials, ausgebildet sind.

15. Akutator nach einem der Ansprüche 1 bis 14, **dadurch gekennzeichnet, dass** das magnetische Formgedächtnislegierungsmaterial aufweisend Ni, Mn, Ga sowie mindestens Co in der Zusammensetzung NiₐMn_{b}Ga_{c}. Co_{d}FeₑCu_{f} ausgewählt ist, wobei a, b, c, d, e und f in Atom-% angegeben sind und die bevorzugt die Bedingungen
44 ≤ a ≤ 51;
19 ≤ b ≤ 30;
18 ≤ c ≤ 24;
0,1 ≤ d ≤ 15;
0 ≤ e ≤ 14,9;
0 ≤ f ≤ 14,9:
d+e+f ≤ 15;
a+b+c+d+e+f = 100;
erfüllen.

16. Aktuator nach einem der Ansprüche 1 bis 15, **dadurch gekennzeichnet, dass** Parallel-Permanentmagnetmittel (52, 54) so magnetisch parallel zu mindestens einer der Spulenvorrichtungen geschaltet sind, dass ein Permanentmagnetfluss der Parallel-Permanentmagnetmittel durch einen zugehörigen Kernabschnitt erfolgen kann,
ein Spulenmagnetfluss der Spulenvorrichtung magnetisch parallel und/oder gleichgerichtet überlagert mit einem über das Antriebselement fließenden Permanentmagnetfluss der Parallel-Permanentmagnetmittel ist
und eine Ansteuerung mindestens einer der Spulenvorrichtungen eine zumindest teilweise Magnetflussverschiebung, insbesondere Magnetflussverdrängung, des Permanentmagnetflusses der Parallel-Permanentmagnetmittel aus dem zugehörigen Kernabschnitt über das Antriebselement bewirkt.

17. Aktuator nach Anspruch 16, **dadurch gekennzeichnet, dass** der mindestens einen Spulenvorrichtung ein Kurzschlussabschnitt der Flussleitmittel außerhalb des zugehörigen Kernabschnitts zum Ausbilden mindestens eines luftspaltfreien magnetischen Flusszweiges zugeordnet ist und die Parallel-Permanentmagnetmittel so magnetisch parallel zu der mindestens einen Spuleneinheit geschaltet sind, dass in einem unbestromten Zustand der Spulenvorrichtung ein Permanentmagnetfluss der Parallel-Permanentmagnetmittel über den Kurzschlussabschnitt in der Art eines magnetischen Kurzschlusses geführt wird,
und die elektrische Ansteuerung der Spuleneinheit die zumindest teilweise Magnetftussverschiebung des Permanentmagnetflusses aus dem Kurzschlussabschnitt in den zugehörigen Kernabschnitt sowie über das Antriebselement bewirkt.

18. Aktuator nach Anspruch 17, **dadurch gekennzeichnet, dass** der Kurzschlussabschnitt als Abschnitt einer flussleitenden Gehäuseschale des Aktuators ausgebildet ist, die die Spulenvorrichtungen mantelseitig umschließt, wobei die Parallel-Pennanentmagnetmittel an und/oder in der Gehäuseschale vorgesehen sind und bevorzugt außen auf der Gehäuseschale aufsitzen oder in einer/m insbesondere langgestreckten und/oder schlitzförmigen Ausnehmung und/oder Durchbruch in der Gehäuseschale aufgenommen sind.

## Claims

1. An actuator with
a drive element of a magnetic shape memory material that can be driven as a reaction to an electrical activation of a plurality of coil devices (10, 12) and designed for purposes of executing an expansion movement as a reaction to the activation, wherein
the coil devices are magnetically connected with the drive element (14) via flux-conducting means (20, 22, 24, 26, 28, 30), and a flux-conducting section of the flux-conducting means is assigned to the coil devices for purposes of interacting with the drive element,
the flux-conducting means for each of the plurality of coil devices have a core section (20, 22, 30) and also a connecting section (24, 26), conducting a magnetic flux to the drive element such that for each of the coil devices a magnetic flux-conducting circuit is formed through the common drive element, and
with reference to the common drive element the flux-conducting circuits are connected magnetically in parallel with each other, and/or a magnetic flux direction of a magnetic flux in the respective flux-conducting circuit in the drive element is aligned in the same directional sense,
**characterised in that**,
in cross-section the drive element is configured in a rectangular and/or polygonal shape and with planar outer surfaces, and no entry of magnetic flux into the drive element takes place along a longest axis or extent dimension of the drive element.

2. The actuator in accordance with Claim 1, **characterised in that** two of the plurality of coil devices are spaced apart from one another and are preferably arranged opposite one another with reference to the drive element.

3. The actuator in accordance with Claim 1 or 2, **characterised in that** a common flux-conducting section is coupled into the flux-conducting circuits so as to interact with the drive element.

4. The actuator in accordance with Claim 1 or 2, **characterised in that** a first flux-conducting section (28) of the flux-conducting means is assigned to a first of the plurality of the coil devices so as to interact with the drive element,
a second flux-conducting section (30) of the flux-conducting means is assigned to at least one other (12) of the plurality of the coil devices so as to interact with the drive element,
and the first (28) and the second (30) flux-conducting sections are provided adjacent to one another, and are designed to be magnetically separated and/or decoupled from one another such that a reciprocal magnetic flux transfer and/or magnetic flux coupling between the first and the second flux-conducting sections is prevented or reduced, in particular in comparison to a common and/or one-piece flux-conducting body to be provided instead of the first and the second flux-conducting sections.

5. The actuator in accordance with Claim 4, **characterised in that** the first and the second flux-conducting sections at least in some sections are designed to be extended and running parallel to one another, and also are designed to be jointly contacting the drive element for the introduction of a magnetic flux.

6. The actuator in accordance with one of the Claims 1 to 5, **characterised in that** the flux-conducting section and the connecting section are of stirrup-shaped, preferably one-piece, design, and/or are formed from a single piece or multiple pieces of a magnetically conducting sheet material.

7. The actuator in accordance with one of the Claims 1 to 6, **characterised in that** a closed magnetic flux-conducting circuit is assigned to each of the plurality of coil devices such that the coil device is provided around a respective core section of the flux-conducting circuit, the flux-conducting section is designed to be opposite to the core section in the flux-conducting circuit, and the plurality of the core sections (20, 22) assigned to the coil devices, with reference to the drive element is arranged radially outwards and/or extending relative to one another with parallel axes.

8. The actuator in accordance with one of the Claims 1 to 7, **characterised by** permanent magnetic means (36-54), which as a section of a permanent magnetic material are connected with the flux-conducting means in a magnetically flux-conducting manner, and/or are coupled into a magnetic flux-conducting circuit for at least one of the flux-conducting sections.

9. The actuator in accordance with Claim 8, **characterised in that** the permanent magnetic means (36-50) are coupled into the magnetic flux-conducting circuit such that in a de-energised activation state of a related coil device a permanent magnetic flux flows through a core section of the magnetic flux-conducting circuit and the permanent magnetic flux, as a reaction to the electrical activation of the coil device and a flux component thereby caused, is displaced into the related flux-conducting section and the drive element.

10. The actuator in accordance with Claim 8 or 9, **characterised in that** the permanent magnetic means (36-50), as a body magnetised in a magnetic flux direction, is part of the flux-conducting section or one of the flux-conducting sections, of one of the core sections assigned to the coil devices, and/or of a connecting section connecting the core section with the drive element of a relevant magnetic flux-conducting circuit.

11. The actuator in accordance with one of the Claims 8 to 10, **characterised in that** the permanent magnetic means (36, 38) are designed as one or a plurality of bodies of a permanent magnetic material preferably commonly assigned to the flux-conducting section/s.

12. The actuator in accordance with one of the Claims 1 to 11, **characterised in that** at least one of the coil devices is provided as a wire winding directly on a core section of the flux-conducting means, without an intermediate coil body.

13. The actuator in accordance with one of the Claims 1 to 12, **characterised by** restoring means assigned to the drive element, which are mechanically coupled with the drive element, and are preferably implemented as an additional counteracting actuator having a shape memory material, or by means of a permanent magnet, and/or as an energy store.

14. The actuator in accordance with one of the Claims 1 to 13, **characterised by** housing means, which are designed as a shell of a magnetically conducting material and/or an insert moulding, in particular by means of a plastic material, at least partially surrounding the actuator and/or the coil means.

15. The actuator in accordance with one of the Claims 1 to 14, **characterised in that** the magnetic shape memory alloy material having Ni, Mn, Ga and also at least Co in the composition NiₐMn_{b}Ga_{c}Co_{d}FeₑCu_{f} is selected, wherein a, b, c, d, e and f are specified in atom-%, and which preferably fulfil the conditions:
44 ≤ a ≤ 51;
19 ≤ b ≤ 30;
18 ≤ c ≤ 24;
0.1 ≤ d ≤ 15;
0 ≤ e ≤ 14.9;
0 ≤ f ≤14.9:
d+e+f ≤ 15;
a+b+c+d+e+f = 100.

16. The actuator in accordance with one of the Claims 1 to 15, **characterised in that** permanent magnetic means (52, 54) are connected magnetically in parallel to at least one of the coil devices such that a permanent magnetic flux of the parallel-permanent magnet means can occur through a related core section,
a coil magnetic flux of the coil unit is magnetically parallel and/or in an equally directed manner overlaid with a permanent magnetic flux of the parallel-permanent magnetic means flowing across the drive element,
and an activation of at least one of the coil devices causes an at least partial magnetic flux shift, in particular a magnetic flux displacement, of the permanent magnetic flux of the parallel-permanent magnetic means from the related core section via the drive element.

17. The actuator in accordance with Claim 16, **characterised in that** a short-circuit section of the flux-conducting means outwards of the related core section is assigned to the at least one coil device so as to form at least one magnetic flux arm with no air gap, and the parallel-permanent magnetic means are connected magnetically in parallel to the at least one coil unit such that in a de-energised state of the coil device a permanent magnetic flux of the parallel-permanent magnetic means is managed via the short-circuit section in the form of a magnetic short-circuit,
and the electrical activation of the coil unit causes the at least partial magnetic flux displacement of the permanent magnetic flux out of the short-circuit section into the related core section and also via the drive element.

18. The actuator in accordance with Claim 17, **characterised in that** the short-circuit section is designed as a section of a flux-conducting housing shell of the actuator, which encloses the coil devices inside the casing, wherein the parallel-permanent magnetic means are provided on and/or in the housing shell, and are preferably located externally on the housing shell or are accommodated in an in particular extended and/or slot-shaped recess and/or opening in the housing shell.

## Revendications

1. Actionneur, avec un élément d'entraînement en un matériau magnétique à mémoire de forme pouvant être entraîné en réaction à une excitation électrique d'une pluralité de dispositifs de bobines (10, 12) et réalisé pour exécuter un mouvement d'expansion en réaction à l'excitation, les dispositifs de bobines étant reliés magnétiquement à l'élément d'entraînement (14) via des moyens de guidage de flux (20, 22, 24, 26, 28, 30), et un segment de guidage de flux des moyens de guidage de flux étant affecté aux dispositifs de bobines pour la coopération avec l'élément d'entraînement, les moyens de guidage de flux présentant, pour chacun de la pluralité des dispositifs de bobines, un segment de noyau (20, 22, 30) ainsi qu'un segment de liaison (24, 26) guidant un flux magnétique vers l'élément d'entraînement de manière à former pour les dispositifs de bobines respectivement un circuit de guidage de flux magnétique à travers l'élément d'entraînement commun, et les circuits de guidage de flux étant magnétiquement montés en parallèle les uns par rapport aux autres par rapport à l'élément d'entraînement commun et/ou une direction de flux magnétique d'un flux magnétique étant orientée de manière identique dans le circuit de guidage de flux respectif dans l'élément d'entraînement, **caractérisé en ce que** l'élément d'entraînement est réalisé avec une forme rectangulaire et/ou polygonale en coupe transversale et avec des surfaces extérieures planes, et une entrée de flux magnétique dans l'élément d'entraînement ne s'effectue pas le long d'un axe le plus long ou d'une dimension d'extension la plus longue de l'élément d'entraînement.

2. Actionneur selon la revendication 1, **caractérisé en ce que** deux de la pluralité des dispositifs de bobines sont disposés de manière espacée l'un de l'autre et de préférence de manière à se situer en vis-à-vis l'un de l'autre par rapport à l'élément d'entraînement.

3. Actionneur selon la revendication 1 ou 2, **caractérisé en ce qu'**un segment de guidage de flux commun est introduit dans les circuits de guidage de flux pour la coopération avec l'élément d'entraînement.

4. Actionneur selon la revendication 1 ou 2, **caractérisé en ce que** l'on affecte, à un premier de la pluralité des dispositifs de bobines, un premier segment de guidage de flux (28) des moyens de guidage de flux pour la coopération avec l'élément d'entraînement, un deuxième segment de guidage de flux (30) des moyens de guidage de flux est affecté à au moins un autre (12) de la pluralité des dispositifs de bobines pour la coopération avec l'élément d'entraînement, et les premier (28) et deuxième (30) segments de guidage de flux sont prévus au voisinage l'un de l'autre et sont réalisés de manière à être séparés et/ou découplés magnétiquement l'un de l'autre de façon à empêcher ou réduire une propagation de flux magnétique réciproque et/ou un couplage de flux magnétique réciproque entre les premier et deuxième segments de guidage de flux, en particulier en comparaison avec un corps de guidage de flux commun et/ou d'une seule pièce à prévoir à la place des premier et deuxième segments de guidage de flux.

5. Actionneur selon la revendication 4, **caractérisé en ce que** les premier et deuxième segments de guidage de flux sont réalisés de manière allongée au moins par tronçons et de manière à s'étendre parallèlement l'un par rapport à l'autre ainsi que de manière à contacter en commun l'élément d'entraînement pour l'entrée d'un flux magnétique.

6. Actionneur selon l'une des revendications 1 à 5, **caractérisé en ce que** le segment de guidage de flux et le segment de liaison sont réalisés en forme de cintre, de préférence d'une seule pièce et/ou en un matériau de tôle magnétiquement conducteur d'une seule pièce ou en plusieurs pièces.

7. Actionneur selon l'une des revendications 1 à 6, **caractérisé en ce que** l'on affecte, à chacun de la pluralité des dispositifs de bobines, un circuit de guidage de flux magnétique fermé de manière à ce que, avec le dispositif de bobine prévu autour d'un segment de noyau respectif du circuit de guidage de flux, le segment de guidage de flux est réalisé de manière à se situer en vis-à-vis du segment de noyau dans le circuit de guidage de flux et que la pluralité des segments de noyau (20, 22) affectés aux dispositifs de bobines sont prévus radialement vers l'extérieur et/ou de manière à s'étendre avec un parallélisme des axes entre eux par rapport à l'élément d'entraînement.

8. Actionneur selon l'une des revendications 1 à 7, **caractérisé par** des moyens d'aimants permanents (36-54) qui sont reliés, en tant que segment en un matériau d'aimant permanent, aux moyens de guidage de flux de manière à guider magnétiquement le flux et/ou qui sont introduits dans un circuit de guidage de flux magnétique pour au moins l'un des segments de guidage de flux.

9. Actionneur selon la revendication 8, **caractérisé en ce que** les moyens d'aimants permanents (36-50) sont introduits dans le circuit de guidage de flux magnétique de manière à ce que, dans un état d'excitation sans alimentation d'un dispositif de bobine associé, un flux d'aimant permanent s'écoule à travers un segment de noyau du circuit de guidage de flux magnétique et que le flux d'aimant permanent, en réaction à l'excitation électrique du dispositif de bobine et à une composante de flux produite de ce fait, est refoulé dans le segment de guidage de flux associé et dans l'élément d'entraînement.

10. Actionneur selon la revendication 8 ou 9, **caractérisé en ce que** les moyens d'aimants permanents (36-50), en tant qu'un corps magnétisé dans une direction de flux magnétique, sont une partie du segment de guidage de flux ou de l'un des segments de guidage de flux, d'un segment de noyau affecté à l'un des dispositifs de bobines et/ou d'un segment de liaison reliant le segment de noyau à l'élément d'entraînement d'un circuit de guidage de flux magnétique concerné.

11. Actionneur selon l'une des revendications 8 à 10, **caractérisé en ce que** les moyens d'aimants permanents (36, 38) sont réalisés en tant qu'un corps constitué du matériau d'aimant permanent affecté à l'un, ou à une pluralité, des segments de guidage de flux, de préférence en commun.

12. Actionneur selon l'une des revendications 1 à 11, **caractérisé en ce qu'**au moins l'un des dispositifs de bobines est prévu en tant qu'enroulement de fils, sans corps de bobine situé entre, directement sur un segment de noyau des moyens de guidage de flux.

13. Actionneur selon l'une des revendications 1 à 12, **caractérisé par** des moyens de rappel affectés à l'élément d'entraînement, lesquels sont couplés mécaniquement avec l'élément d'entraînement et sont de préférence réalisés en tant qu'actionneur supplémentaire à effet antagoniste présentant un matériau à mémoire de forme, ou au moyen d'un aimant permanent et/ou en tant qu'accumulateur d'énergie.

14. Actionneur selon l'une des revendications 1 à 13, **caractérisé par** des moyens de boîtier qui sont réalisés en tant que coque en un matériau magnétiquement conducteur et/ou enrobage, en particulier à l'aide d'un matériau synthétique, entourant au moins partiellement l'actionneur et/ou les moyens de bobines.

15. Actionneur selon l'une des revendications 1 à 14, **caractérisé en ce que** le matériau magnétique d'alliage à mémoire de forme présentant du Ni, Mn, Ga ainsi qu'au moins du Co est sélectionné dans la composition NiₐMn_{b}Ga_{c}Co_{d}FeₑCu_{f}, a, b, c, d, e et f étant indiqués en % atomique et satisfaisant de préférence aux conditions suivantes :
44 ≤ a ≤ 51 :
19 ≤ b ≤ 30;
18 ≤ c ≤ 24;
0,1 ≤ d ≤ 15;
0 ≤ e ≤ 14,9;
0 ≤ f ≤ 14,9:
d+e+f ≤ 15;
a+b+c+d+e+f = 100

16. Actionneur selon l'une des revendications 1 à 15, **caractérisé en ce que** des moyens d'aimants permanents parallèles (52, 54) sont montés de manière magnétique parallèlement à au moins l'un des dispositifs de bobines de façon à ce qu'un flux d'aimant permanent des moyens d'aimants permanents parallèles puisse avoir lieu à travers un segment de noyau associé,
un flux d'aimant permanent des moyens d'aimants permanents parallèles s'écoulant via l'élément d'entraînement se superposant à un flux magnétique de bobine du dispositif de bobine de manière magnétiquement parallèle et/ou dans le même sens, et une excitation d'au moins l'un des dispositifs de bobines provoque un déplacement de flux magnétique au moins partiel, en particulier un refoulement de flux magnétique, du flux d'aimant permanent des moyens d'aimants permanents parallèles, du segment de noyau associé via l'élément d'entraînement.

17. Actionneur selon la revendication 16, **caractérisé en ce que** l'on affecte, à l'au moins un dispositif de bobine, un segment de court-circuitage des moyens de guidage de flux en dehors du segment de noyau associé pour former au moins une branche de flux magnétique sans entrefer et les moyens d'aimants permanents parallèles sont montés magnétiquement en parallèle à l'au moins une unité de bobine de manière à ce que, dans un état non alimenté du dispositif de bobine, un flux d'aimant permanent des moyens d'aimants permanents parallèles soit guidé via le segment de court-circuitage à la manière d'un court-circuit magnétique,
et l'excitation électrique de l'unité de bobine provoque le déplacement de flux magnétique au moins partiel du flux d'aimant permanent depuis le segment de court-circuitage vers le segment de noyau associé ainsi que via l'élément d'entraînement.

18. Actionneur selon la revendication 17, **caractérisé en ce que** le segment de court-circuitage est réalisé en tant que segment d'une coque de boîtier de guidage de flux de l'actionneur qui entoure les dispositifs de bobines côté enveloppe, dans lequel les moyens d'aimants permanents parallèles sont prévus sur et/ou dans la coque de boîtier et sont de préférence apposés à l'extérieur sur la coque de boîtier ou bien sont réceptionnés dans un évidement et/ou un passage en particulier allongé et/ou en forme de fente dans la coque de boîtier.
